(19) Europäisches Patentamt
European Patent Office
Office européen des brevets

(11) Publication number: **0 261 910 B1**

(12) **EUROPEAN PATENT SPECIFICATION**

(45) Date of publication of patent specification: **30.03.94** (51) Int. Cl.$^5$: **G03F 7/033**

(21) Application number: **87308332.3**

(22) Date of filing: **21.09.87**

(54) **Water-developable photosensitive plate and its production.**

(30) Priority: **22.09.86 US 910134**

(43) Date of publication of application:
**30.03.88 Bulletin 88/13**

(45) Publication of the grant of the patent:
**30.03.94 Bulletin 94/13**

(84) Designated Contracting States:
**AT BE CH DE ES FR GB GR IT LI LU NL SE**

(56) References cited:
**EP-A- 0 162 570**
**EP-A- 0 198 392**
**DE-A- 2 816 774**
**US-A- 3 764 324**
**US-A- 4 245 031**
**EP-A- 0 164 270**
**EP-A- 0 251 228**
**US-A- 2 893 868**
**US-A- 4 239 849**
**US-A- 4 415 649**

(73) Proprietor: **Nippon Paint Co. Ltd.**
**1-2, Oyodokita 2-chome**
**Kita-ku**
**Osaka-shi Osaka-fu(JP)**

(72) Inventor: **Ishikawa, Katsukiyo**
**14-19, Sennichi-cho**
**Yamatokoriyama-shi Nara-ken(JP)**
Inventor: **Konishi, Katsuji**
**4472 Honmachi**
**Izumisano-shi Osaka-fu(JP)**
Inventor: **Kusuda, Hidefumi**
**1-13, Higashi-Funabashi**
**Hirakatashi Osaka-fu(JP)**

(74) Representative: **Votier, Sidney David et al**
**CARPMAELS & RANSFORD**
**43, Bloomsbury Square**
**London WC1A 2RA (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

This invention relates to a water-developable photosensitive plate and its production. More particularly, it relates to a water-developable photosensitive resin plate having a solid form stability, which is suitable for the manufacture of a printing plate, especially a relief printing plate, having excellent chemical and physical properties such as high resistance to water based inks, high abrasion resistance and good resilience.

A photosensitive resin plate for the manufacture of a relief printing plate is preferably developable with water rather than organic solvents for various reasons such as easiness of handling, health of the working people, safety, and avoidance of environmental pollution. On printing with a relief printing plate resulting from the photosensitive resin plate, it is also very desirable to be able to use water based inks, because oil based inks tend to mist and hence to cause health problems. In addition, the use of water based inks is favored in that the resulting print will not show through the printed paper from one side to the other and does not tend to rub off on the fingers.

There are various known photosensitive resin plates. The photosensitive resin compositions for those conventional photosensitive resin plates are based on liquid unsaturated polyesters, polyvinyl alcohols, water soluble polyamides, cellulose acetate succinates, alcohol soluble polyamides, etc. All these materials, however, suffer from significant disadvantages. For instance, the liquid unsaturated polyesters are inconvenient to handle and necessitate the use of an alkaline solution or a special air knife for developing. The polyvinyl alcohols and the water soluble polyamides have extremely low resistance to water, and consequently water based inks are not usable. The cellulose acetate succinates require the use of an alkaline solution for development, and the alcohol soluble polyamides require the use of an inflammable alcohol.

U.S. patent 3,801,328 discloses a water developable photopolymerizable composition for preparation of a photosensitive resin plate, said composition comprising unsaturated ethylenic monomers, a photopolymerization initiator and a partially saponified polyvinyl acetate. This composition has been found to be developed very satisfactorily with water to give a relief printing plate. However, the water resistance of this relief printing plate at the surface is low, which in turn precludes its use with a water based ink.

US-A-2893868 discloses an addition polymerizable composition comprising (a) an addition polymer having a molecular weight of at least 2500, a wholly carbon chain and a plurality of one type of extra-linear salt-forming groups selected from acidic carboxylic, sulphonic, phosphonic, sulphate, and phosphate types and basic amino types, (b) at least one ethylenically unsaturated, addition polymerizable monomer capable of forming a high polymer by photoinitiated addition polymerization in the presence of an addition polymerization initiator therefor activatable by actinic light and having at least one complementary salt-forming group from the aforesaid class, and (c) an addition polymerization initiator activatable by actinic light in an amount from 0.1 to 5.0%, by weight, of said composition. These compositions may be used to making printing reliefs.

EP-A-0162570 discloses a conjugated diene copolymer comprising specified amounts of (A) conjugated diene compound units, (B) $\alpha$, $\beta$-ethylenically unsaturated carboxylic acid units, (C) polyfunctional alkenyl compound units, and optionally (D) diene compound units having carbon-carbon double bonds in a carbocyclic system and optionally (E) monoolefinically unsaturated compound units. Such copolymers may be used for making photosensitive compositions.

According to this invention a method for preparing a water-developable photo-sensitive resin plate suitable for the manufacture of a relief printing plate having high resistance to water-based inks, high resilience and excellent form stability, comprises:

(A) a copolymer comprising units of (i) an aliphatic conjugated diene monomer, (ii) an $\alpha$, $\beta$-ethylenically unsaturated carboxylic acid and (iii) a polyfunctional vinyl monomer, optionally with (iv) a monofunctional vinyl monomer, the content of the aliphatic conjugated diene monomer (i), the $\alpha$, $\beta$-ethylenically unsaturated carboxylic acid (ii), the polyfunctional vinyl monomer (iii) and the monofunctional vinyl monomer (iv) being respectively from about 61 to 95 mol % from about 2.5 to 10 mol %, from about 0.5 to 3 mol % and 0 to 70 mol % based on the combination of those monomeric components;

(B) a basic nitrogen atom-containing compound;

(C) an ethylenically unsaturated monomer; and

(D) a photopolymerization initiator, characterized in that a photosensitive composition comprising uniformly the components (A), (B), (C) and (D) without any solvent is molded in a melt state into an appropriate shape.

Also according to this invention a water developable photosensitive resin plate suitable for the manufacture of a relief printing plate highly resistant to water based inks, comprises (A) a copolymer comprising (i) an aliphatic conjugated diene monomer, (ii) an $\alpha$, $\beta$ -ethylenically unsaturated carboxylic acid and (iii) a polyfunctional vinyl monomer, optionally with (iv) a monofunctional vinyl monomer, the content of

the aliphatic conjugated diene monomer (i), the α, β -ethylenically unsaturated carboxylic acid (ii), the polyfunctional vinyl monomer (iii) and the monofunctional vinyl monomer (iv) being respectively from about 61 to 95 mol%, from about 2.5 to 10 mol %, from about 0.5 to 3 mol % and 0 to 70 mol % based on the combination of those monomeric components, (B) a basic nitrogen atom-containing compound, (C) an ethylenically unsaturated monomer and (D) a photopolymerization initiator.

As stated above, the photosensitive resin plate of the invention is characterized by good water developability, and the printing plate obtained therefrom is characterized by high water resistance. Both the photosensitive resin plate and the printing plate are also characterized by having excellent solid form stability, i.e., shape and size stability. In addition, the printing plate has high abrasion resistance and good resilience. Therefore, the printing plate is particularly suitable for flexographic printing, which is often carried out with water based inks.

The photosensitive resin plate of the invention comprises a polymerizable composition comprising the components (A), (B), (C) and (D), as defined above, applied in an appropriate form such as a layer, a film, a sheet or a plate, on an appropriate support material such as a plastic plate, a plastic sheet, a metal plate or a metal sheet.

The copolymer (A) comprises units of the components (i), (ii) and (iii) as the essential components, with or without units of the optional component (iv). The copolymer (A) comprises units of the aliphatic conjugated diene monomer (i), the α, β -ethylenically unsaturated carboxylic acid (ii) and the polyfunctional vinyl monomer (iii), respectively, in amounts of 5 to 95 mol% (preferably from 40 to 85 mol%), 1 to 30 mol% (preferably from 2.5 to 10 mol %) and 0.1 to 10 mol % (preferably from 0.5 to 3 mol %), on the basis of the combination of all the monomeric components therein. Further, the copolymer (A) may comprise optionally units of the monofunctional vinyl monomer (iv) in an amount of not more than 70 mol %, on the basis of the combinaltion of all the monomeric components therein.

Examples of the aliphatic conjugated diene monomer (i) are butadiene, isoprene, dimethylbutadiene, chloroprene, etc. Examples of the α, β -ethylenically unsaturated carboxylic acid (ii) are acrylic acid, methacrylic acid, maleic acid, fumaric acid, citraconic acid, crotonic acid, etc. Examples of the polyfunctional vinyl monomer (iii) are trimethylolpropane di(meth)acrylate, trimethylolpropane tri(meth)acrylate, divinylbenzene, ethylenglycol di(meth)acrylate, pentaerythritol tri(meth)acrylate, pentaerythritol tetra(meth)-acrylate, 1,4-butanediol di(meth)arylate, 1,6-hexanediol di(meth)acrylate, etc. Examples of the monofunctional vinyl monomer (iv) are styrene, α-methylstyrene, vinyltoluene, acrylonitrile, vinyl chloride, vinylidene chloride, acrylamide, methacrylamide, methyl (meth)acrylate, ethyl (meth)acrylate, n-propyl (meth)acrylate, n-butyl (meth)acrylate, acrylate, 2-ethylhexyl (meth)acrylate, etc. Each of the above components (i) to (iv) may consist of one or more of the monomers as exemplified above.

When the amount of the aliphatic conjugated diene monomer (i) is less than the indicated lower limit, the resilience of the printing plate is inferior. When it is more than the upper limit, the water developability of the photosensitive resin plate becomes poor. When the amount of the α, β -ethylenically unsaturated carboxylic acid (ii) is less than said lower limit, the water developability of the photosensitive resin plate becomes lower. When it is more than said upper limit, the water-resistance of the printing plate is inferior. When the amount of the polyfunctional vinyl monomer (iii) is less than said lower limit, the moldability of the photosensitive resin plate is lowered, whereas, when it is more than the upper limit, the resilience of the printing plate is lost. In the copolymer (A), the units of the polyfunctional vinyl monomer are believed to be covalently crosslinked and thus to contribute to solid form stability, water resistance, water-developability, and moldability.

The copolymer (A) may be prepared by conventional polymerization procedures. For instance, a mixture of the monomers may be subjected to emulsion polymerization in an aqueous medium containing potassium persulfate as a catalyst and sodium docecylbenzenesulfonate as an emulsifier at a temperature of about 15 to 20 °C.

The basic nitrogen-atom containing compound (B) is a compound having a tertiary basic nitrogen atom and preferably includes a vinyl group. Examples of suitable such compounds are N,N-dimethylaminoethyl (meth)acrylate, N,N-dimethylaminopropyl (meth)acrylamide, N,N-dimethylaminoethyl-N′-(meth)-acryloylcarbamate, N,N-dimethylaminoethoxyethanol, N,N-dimethylaminoethoxyethoxyethanol, N,N-diethylaminoethoxyethyl (meth)acrylate, which may be used alone or in combination. In general, the nitrogen atom containing compounds may be depicted by the following structural formulas:

(I)

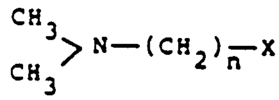

n = 1, 2 or 3

X =

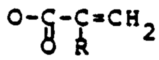 , 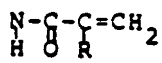 , or 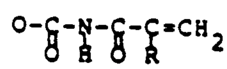

R = H or $CH_3$

(II)

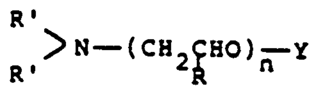

Y = H,

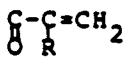 , or 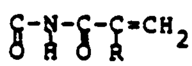

R = H or $CH_3$; n is 1 to 6 when R' is $CH_3$ and 2 to 6 when R'is $C_2H_5$.

Preferred compounds are those of the foregoing structural formulas, except those of formula II when Y is H. Other non-photopolymerizable amine compounds, such as 2-N-morpholinoethanol and 2-piperidinoethanol, may be used, in combination with the compounds mentioned in formula I or II.

The ethylenically unsaturated monomer (C) may be any compound having ethylenic unsaturation. Specific examples are unsaturated carboxylic esters (e.g., n-butyl (meth)acrylate, 2-ethylhexyl (meth)-acrylate, lauryl (meth)acrylate, stearyl (meth)acrylate, polyethylene glycol mono(meth)acrylate, methoxypolyethylene glycol mono(meth)acrylate, polypropylene glycol mono(meth)acrylate, phenoxypolyethylene glycol mono(meth)acryl ate, ethylene glycol di(meth)acrylate, diethylene glycol di(meth)acrylate, triethylene glycol di(meth)acrylate, diallyl itaconate, glycerol di(meth)acrylate, glycerol tri(meth)acrylate, 1,3-propylene glycol di(meth)acrylate, 1,4-cyclohexanediol di(meth)acrylate, 1,2,4-butanetriol tri(meth)acrylate, glycerol polypropylene glycol tri(meth)acrylate, 1,4-benzenediol di(meth)acrylate, pentaerythritol tetra(meth)acrylate, tetramethylene glycol di(meth)acrylate, 1,5-pentanediol di(meth)acrylate, 1,6-hexanediol di(meth)acrylate, unsaturated amides (e.g. methylene bis (meth)acrylamide, ethylene bis(meth)acrylamide, 1,6-hexamethylene bis(meth)acrylamide, diethylenetriamine tris(meth)acrylamide, N-(hydroxymethyl)acryamide, N-(hydroxymethyl)methacrylamide, N-($\beta$ -hydroxyethyl)acrylamide, N-($\beta$-hydroxyethyl)methacrylamide, N,N'-bis($\beta$-hydroxyethyl)acrylamide, N-N'-bis($\beta$-hydroxyethyl)methacrylamide), divinyl esters (e.g., divinyl adipate, divinyl phthalate), acrylated or methacrylated urethanes derived from hydroxyalkyl acrylates or hydroxyalkyl methacrylates and isocyanate compounds, diacrylic or dimethacrylic esters or diepoxypolyethers derived from aromaltic compounds with polyalcohols such as bisphenol or Novolac compounds, etc. One or more of these compounds may be used, and generally water-incompatible monomers are preferred.

The ethylenically unsaturated monomer (c) preferably includes a polyfunctional monomer to provide greater water resistance to the printing plates produced from the composition. Polyfunctional monomers that are compatible with the resin system may be used, including those identified above, as well as those described in U.S. patent 3,801,328, the disclosure of which is incorporated by reference herein. In the resin system of this invention, use of the polyfunctional monomer has been found to provide printing plates with increased water resistance, but does not impede the ability of the plates to be developed solely with water.

Examples of the photopolymerization initiator (D) are benzoin ethers (e.g. benzoin isopropyl ether, benzoin isobutyl ether), benzophenones (e.g., benzophenone, methyl o-benzoylbenzoate), xanthones (e.g.,

xanthone, thioxanthone, 2-chlorothioxanthone), acetophenones (e.g., acetophenone, trichloroacetophenone, 2,2-diethoxyacetophenone, 2,2-dimethoxy-2-phenylacetophenone), benzil, 2-ethylanthraquinone, methyl benzoylformate, 2-hydroxy-2-methylpropiophenone, 2-hydroxy-2-methyl-4'-isopropyl-isopropiophenone, 1-hydroxycyclohexylphenylketone, etc. They may be used alone or in combination.

In the photosensitive resin plate, the copolymer (A), the ethylenically unsaturated monomer (C) and the photopolymerization initiator (D), respectively may be from about 30 to 90 % by weight, from about 5 to 69.99 % by weight and from about 0.01 to 10% by weight. When the copolymer (A) is less than the indicated 30 weight %, it has been found that a satisfactory solid plate cannot be formed; if the copolymer exceeds approximately 90%, the photosensitive resin will not cure adequately. If the ethylenically unsaturated monomer (C) is less than about 5%, the composition will not cure adequately, and if it is more than about 70%, the solid retention is not good. If the photo-initiator (D) is used in a quantity less than 0.01%, the composition is not sufficiently light sensitive. If the photo-initiator is used in a quantity greater than about 10%, the resulting plate, following light exposure and development, will not provide an acceptable image. The amount of the basic nitrogen atom-containing compound (B) may be from about 0.20 to 2.0 mol to 1 mol of the carboxyl groups in the copolymer (A). When the amount of the basic nitrogen atom-containing compound (B) is less than said lower limit, the water developability of the photosensitive resin plate becomes poor. When more than said upper limit, the water resistance of the printing plate deteriorates.

For preparation of the photosensitive resin plate of the invention, a photosensitive resin composition comprising a uniform mixture of the components (A), (B), (C) and (D), may be molded in a melt state into an appropriate shape (e.g., sheet, plate) by a conventional procedure such as by extruding or calendering. The photosensitive resin composition may comprise additionally and optionally any conventional additives such as polymerization inhibitors (e.g., hydroquinone, hydroquinone monomethyl ether, mono-t-butylhydroquinone, catechol, p-t-butyl-catechol, 2,6-di-t-butyl-p-cresol, benzoquinone, 2,5-diphenyl-p-benzoquinone, phenothiazine), dyes (e.g., eosin Y, rose-bengal), and plasticizers (e.g., dialkyl phthalate, dialkyl fumarate, dialkyl sebacate, dialkyl itaconate, alkyl phosphate, polyethyleneglycol, polyethyleneglycol esters, polyethyleneglycol ethers).

For preparation of the relief printing plate, the photosensitive resin plate as above obtained is exposed to an actinic light source, such as ultraviolet light, through a negative film having an appropriate image so that the photo-polymerization takes place at the exposed areas to give a latent image. Development by washing out the photosensitive resin composition at the non-exposed areas with water gives a visible image, whereby a relief printing plate having high resistance to water and usable with water based inks is obtained. Advantageously, the relief printing plate has high abrasion resistance and good resilience so that it is quite suitable for flexographic printing.

The present invention will be hereinafter explained more in details by Examples and Comparative Examples wherein part(s) and % are by weight unless otherwise indicated.

The following methods are advantageously used to prepare the primer coat on the metal plate.

Method A

The surface of the iron plate had been previously coated with a primer of the following composition: 50 parts of an ammonia dispersion (A) comprising a copolymer of 49 mol % of butadiene, 7.5 mol % of methacrylic acid, 1.5 mol % of ethylene glycol dimethacrylate, 39 mol % of ethyl acrylate and 3 mol % of dicyclopentenyl oxyethyl acrylate and having a pH of 9.3, a viscosity of 25 cps/25 °C and a solid content of 18.5%, 20 parts of an ammonia dispersion (B) comprising a copolymer of ethylene and acrylic acid and having a pH of 9.3, a viscosity of 1,500 cps/25 °C and a solid content of 34 %, 25 parts of a deionized aqueous solution (C) comprising 50 % of a phthalocyanin paste and an epoxy type hardening agent and 5 parts of n-butanol (D). The primer coating has a viscosity of 2,500 cps/25 °C and was applied continuously onto a degreased, tin-free steel plate of 0.18 mm in thickness by the aid of a reverse coater, followed by drying in a gas furnace at 200 °C for 2 minutes. The final primer coating thickness was about 10 microns.

Method B

An aqueous dispersion of polyurethane, well mixed with pigment paste, was used as a primer solution. The solid content was approximately 30 weight %, and the viscosity was about 1300 cps/25 °C by Brookfield viscometer.

After the solution was applied onto a degreased steel plate, the coated substrate was dried for about 2 minutes at about 150 °C. After drying, the primer thickness was approximately 10-15 μ.

Example 1

To a copolymer (60 parts) comprising 49 mol % of butadiene, 7.5 mol % of methacrylic acid, 1.5 mol % of ethylene glycol dimethacrylate and 42 mol % of ethyl acrylate, were added N,N-dimethylaminoethylmethacrylate (5 parts; 0.51 mol to 1 mol of the carboxyl groups in the copolymer), phenoxyethoxyethanol (5 parts), methoxytripropyleneglycol acrylate (10 parts), nonaethylene glycol diacrylate (12 parts), trimethylolpropane trimethacrylate (5 parts), 2,2-dimethoxy-2-phenylacetophenone (1.6 parts), 2,6-di-t-butyl-p-cresol (0.3 part), p-methoxyphenol (0.1 part) and stearic acid (1.0 part). The resultant mixture was kneaded well by the aid of a pressurized two arm kneader. The thus obtained photosensitive resin composition was extruded through a kneader-extruder equipped with a T-die onto an iron plate to make a laminated plate having a photosensitive resin layer of about 0.40 mm in thickness with a mirror surface.

Onto the surface of the photosensitive resin layer of the photosensitive resin plate, a negative film having an appropriate image was closely contacted in vacuo, and irradiation was made with a 350 W chemical lamp for 1 minute, followed by development in water at 40 °C to give a printing plate having a relief image exactly corresponding to that of the negative film.

Using the printing plate, printing was carried out with an aqueous flexographic ink by the aid of a flexographic printing machine under a printing condition of 600 feet/minute. After printing 150,000 copies, no material change was produced at the surface of the printing plate.

Comparative Example 1 (Canadian patent 613,952)

To a copolymer (15 parts) comprising 82.7 mol% of butadiene and 17.3 mol% of methacrylic acid, 2-diethylaminoethyl methacrylate (3 parts; 0.4 mol to 1 mol of the carboxyl groups in the copolymer), hydroquinone (0.2 parts) and benzoin methyl ether (1 part) were added, followed by further addition of a mixture of dioxane-ethanol (90 : 10) (85 parts) thereto. The resultant mixture was stirred well to make a uniform solution. At the edge portions on the four sides of the same iron plate as used in Example 1, a bank was provided, and said solution was poured within the bank. The resultant iron plate was allowed to stand in a dark place at room temperature, during which the solvent was evaporated to make a photosensitive resin layer of about 0.58 mm in total thickness, whereby a photosensitive resin plate was obtained.

Onto the surface of the photosensitive resin layer of the photosensitive resin plate, a negative film having an appropriate image was closely contacted in vacuo, and irradiation was made with a 350 W chemical lamp for 1 minute, followed by development in 1 % aqueous sodium carbonate solution for 3 minutes to give a printing plate having a relief image of 0.08 mm in depth.

When dipped in an aqueous flexographic ink for newspaper at 40 °C for 2 hours, the printing plate gave a thickness swelling rate of 35 %.

A plate of identical composition could not be processed with water.

Comparative Example 2

In the same manner as in Example 1 but replacing the copolymer by a copolymer (60 parts) comprising 82.7 mol% of butadiene and 17.3 mol% of methacrylic acid and adjusting the molar ratio of N,N-dimethylaminoethyl methacrylate to the carboxyl groups in the copolymer to 0.18, there was prepared a photosensitive resin composition. This composition was extruded to make a sheet, which was simultaneously laminated at 80 °C on one surface of a supporting plate with intervention of a spacer by the aid of a press to make a photosentive resin layer of 0.4 mm in thickness, whereby a photosensitive resin plate was obtained. The photosensitive resin layer was wrinkled at the surface and not suitable for preparation of a printing plate assuring good printing quality.

Example 2

In the same manner as in Example 1 but replacing the copolymer by a copolymer (60 parts) comprising 61 mol% of butadiene, 2.5 mol% of methacrylic acid, 1.5 mol% of ethylene glycol dimethacrylate and 35 mol % of ethyl acrylate and adjusting the molar ratio of N, N-dimethylaminopropylacrylamide to the carboxyl groups in the copolymer to 1.53, there was prepared a photosensitive resin composition. This composition was extruded to make a sheet, which was simultaneously laminated at 80 °C on one surface of a supporting plate with intervention of a spacer by the aid of a press to make a photosensitive resin layer of 0.4 mm in thickness, whereby a photosensitive resin plate was obtained. Using the printing plate, printing was carried out with an aqueous flexographic ink for newspaper by the aid of a flexographic printing

machine under a printing speed of 120 feet/minute. Printing could be performed smoothly without producing any mottling.

Example 3

In the same manner as in Example 1 but replacing the copolymer by a copolymer (60 parts) comprising 52 mol% of butadiene, 8.5 mol% of methacrylic acid, 2.5 mol% of divinylbenzene and 37 mol% of ethyl acrylate and adjusting the molar ratio of N,N-dimethylaminopropylmethacrylamide to the carboxyl groups in the copolymer to 0.47, there was prepared a photosensitive resin composition. This composition was extruded to make a sheet, which was simultaneously laminated on one surface of a supporting plate to make a photosentive resin layer of 0.4 mm in thickness, whereby a photosensitive resin plate was obtained. Using the printing plate, printing was carried out in the same manner as in Example 1 to give a sharp image.

Example 4

In the same manner as in Example 1 but replacing the copolymer by a copolymer (60 parts) comprising 49 mol% of butadiene, 7.5 mol% of methacrylic acid, 2.5 mol% of 1,4-butanediol diacrylate and 41 mol% of ethyl acrylate and adjusting the molar ratio of N,N-dimethylaminoethyl-N′-methacryloylcarbamate to the carboxyl groups in the copolymer to 0.44, there was prepared a photosensitive resin composition. This composition was extruded to make a sheet, which was simultaneously laminated on one surface of a supporting plate to make a photosentive resin layer of 0.4 mm in thickness, whereby a photosensitive resin plate was obtained. Using the printing plate, printing was carried out in the same manner as in Example 1 to give a sharp image.

Comparative Example 3

In the same manner as in Comparative Example 2 but replacing the copolymer by a copolymer (60 parts) comprising 24 mol% of methacrylic acid, 1 mol% of ethylene glycol dimethacrylate, 59 mol% of ethyl acrylate and 16 mol% of methoxyethyl acrylate and adjusting the molar ratio of N,N-dimethylaminoethyl methacrylate to the carboxyl groups in the copolymer to 0.23, there was prepared a photosensitive resin composition. This composition was extruded to make a sheet, which was simultaneously laminated at 80 °C on one surface of a supporting plate with intervention of a spacer by the aid of a press to make a photosentive resin layer of 0.4 mm in thickness, whereby a photosensitive resin plate was obtained. The photosensitive resin layer had slight roughness at the surface.

In the same manner as in Example 1, a relief image was made using the photosensitve resin plate. When the resultant printing plate was dipped in an aqueous flexographic ink for newspaper at 40 °C for 2 hours, it showed a swelling rate of 4.9% in thickness. The impact resilience as determined by JIS (Japanese Industrial Standard) 6301 was as low as 3 % at 20 °C.

Comparative Example 4

In the same manner as in Comparative Example 2 but replacing the copolymer by a copolymer (60 parts) comprising 7.5 mol% of methacrylic acid, 1.5 mol% of ethylene glycol dimethacrylate, 59 mol% of ethyl acrylate and 32 mol% of methoxyethyl acrylate and adjusting the molar ratio of N,N-dimethylaminoethyl methacrylate to the carboxyl groups in the copolymer to 0.51, there was prepared a photosensitive resin composition. This composition was extruded to make a sheet, which was simultaneously laminated at 80 °C on one surface of a supporting plate with intervention of a spacer by the aid of a press to make a photosensitive resin layer of 0.4 mm in thickness, whereby a photosensitive resin plate was obtained. The photosensitive resin layer has slight roughness at the surface.

In the same manner as in Example 1, a relief image was made using the photosensitive resin plate. When the resultant printing plate was dipped in an aqueous flexographic ink for newspaper at 40 °C for 2 hours, it showed a swelling rate of 4.9% in thickness. The impact resilience as determined by JIS (Japanese Industrial Standard) 6301 was as low as 3% at 20 °C.

Example 5

In the same manner as in Example 1 but using the copolymer as used in Example 1 (65.5 parts), N,N-dimethylaminoethoxyethoxyethanol (5 parts; 0.41 mol to 1 mol of the carboxyl groups in the copolymer), 2-ethylhexyl methacrylate (20 parts), 1,4-butanediol dimethacrylate (2.5 parts), phenoxyethoxyethanol (5 parts), 2,2-dimethoxy-2-phenylacetophenone (1.6 parts), 2,6-di-t-butyl-p-cresol (0.3 part) and p-methoxyphenol (0.1 part), there was prepared a photosensitive resin plate.

Onto the surface of the photosensitive resin layer of the photosensitive resin plate, a negative film having an appropriate image was closely contacted in vacuo, followed by irradiation with a 350 W chemical lamp for 1.2 seconds as bump exposure and 40 seconds as main exposure. Development was effected by washing out with water at 40 °C for 30 seconds to give a printing plate having a relief image.

Using the printing plate, printing was carried out in the same manner as in Example 1 to give a sharp image.

Example 6

To a copolymer (60 parts) comprising 81.5 mol % of butadiene, 4.5 mol % of methacrylic acid, 1.5 mol % of ethylene glycol dimethacrylate and 12.5 mol % of methylmethacrylate, N,N-dimethylaminopropylmethacrylamide (3.6 parts; 0.50 mol to 1 mol of carboxyl groups in the copolymer), 2-N-morpholinoethanol (1.4 parts; 0.25 mol to 1 mol of carboxyl groups in the copolymer), phenoxyethoxyethanol (6 parts), pentapropylene glycol monomethacrylate (18 parts), glycerolpropylene glycol trimethacrylate (6 parts), lauryl methacrylate (3 parts), 2,2-dimethoxy-2-phenyl-acetophenone (1.6 parts), and 2,6-di-t-butyl-p-cresol (0.4 part) were added.

The thus obtained photosensitive resin composition was extruded through a kneader-extruder equipped with a T-die onto the primer coated iron plate to make a laminated plate having a photosensitive resin layer of about 0.4 mm in thickness having a mirror surface.

Using this plate, processing and printing were carried out in the same manner as in Example 1 to give a sharp image.

Some properties of the photosensitive resin plates and the printing plates obtained in Examples and Comparative Examples as above are shown in the following Table.

Table

| Example | Water developability (Time for washing out) (Seconds) | Resilience 20°C (%) | Shore A hardness 20°C (°) | Swelling rate in aqueous ink dipping test 40°C x 2hrs (%) | Alkali developability with 1% $Na_2CO_3$ |
|---|---|---|---|---|---|
| 1 | 30 | 20 | 78 | 2.5 | |
| Comparative 1 | Washing out impossible | 30 | 70 | 35.0 | Relief of 80 µ in depth after 3 minutes |
| Comparative 2 | Washing out impossible | 32 | 68 | 40.0 | Relief of 10 µ in depth after 3 minutes |
| 2 | 35 | 35 | 66 | 1.2 | |
| 3 | 35 | 20 | 78 | 1.8 | |
| 4 | 30 | 20 | 78 | 2.5 | |
| Comparative 3 | 20 | 3 | 81 | 20.0 | |
| Comparative 4 | 30 | 3 | 80 | 4.9 | |
| 5 | 25 | 25 | 72 | 5.2 | |
| 6 | 35 | 28 | 74 | 4.0 | |

It will thus be appreciated from the foregoing, especially the illustrative examples, that the photosensitive printing plate of the present invention is developable with water, and the printing plate therefrom is quite water resistant and capable of use with water based inks. The printing plate is resilient enough to provide an excellent printing quality.

While the invention has been described primarily with respect to relief printing plates, it should be recognized that it may also be used to make plates for offset printing or for screen printing. By the same token, while specific embodiments of the invention have been disclosed, it should be understood that modifications and equivalents of such embodiments as will be apparent to those skilled in the art, are to be within the scope of the invention, as defined by the following claims.

**Claims**

**Claims for the following Contracting States : AT, BE, CH, DE, FR, GB, GR, IT, LI, LU, NL, SE**

1. A water-developable photosensitive resin composition providing water resistance and resilience after development, which comprises:
   (A) a copolymer comprising units of (i) an aliphatic conjugated diene monomer, (ii) an $\alpha$, $\beta$ - ethylenically unsaturated carboxylic acid, and (iii) a polyfunctional vinyl monomer, optionally with (iv) a monofunctional vinyl monomer, the content of the aliphatic conjugated diene monomer (i) the $\alpha$, $\beta$- ethylenically unsaturated carboxylic acid (ii), the polyfunctional vinyl monomer (iii) and the monofunctional vinyl monomer (iv) being respectively from about 61 to 95 mol % from about 2.5 to 10 mol %, from about 0.5 to 3 mol % and 0 to 70 mol % based on the combination of those monomeric components;
   (B) a basic nitrogen atom-containing compound;
   (C) an ethylenically unsaturated monomer; and
   (D) a photopolymerization initiator.

2. The water-developable photosensitive resin composition according to claim 1, wherein the amounts of the copolymer (A), the ethylenically unsaturated monomer (C) and the photopolymerization initiator (D) are respectively from about 30 to 90 % by weight, from about 5 to 69.99 % by weight and from about 0.01 to 10 % by weight, and the amount of the basic nitrogen atom-containing compound (B) is from about 0.20 to 2 mol to 1 mol of the carboxyl groups in the copolymer (A).

3. The water-developable photosensitive resin composition according to claim 1 or 2, wherein the basic nitrogen atom-containing compound (B) is represented by the structural formulae:
   (I)

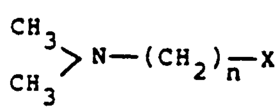

n = 1, 2 or 3
X =

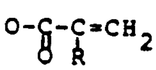 , 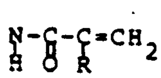 , or 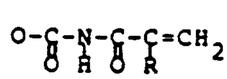

R = H or $CH_3$
(II)

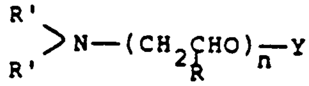

Y = H ,

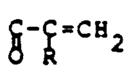 , or 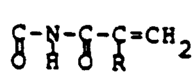

R = H or $CH_3$; n is 1 to 6 when R' is $CH_3$ and 2 to 6 when R' is $C_2H_5$.

**4.** The water-developable photosensitive resin composition according to claim 3, wherein the basic nitrogen atom-containing compound (B) is a photopolymerizable amine compound expressed in formula (I) or (II) except compounds corresponding to formula (II) in which Y is hydrogen.

**5.** The water-developable photosensitive resin composition according to any of claims 1 to 4, which is supported on a supporting material.

**6.** A relief printing plate having high resistance to water-based inks, high resilience and excellent form stability, which is prepared by the use of the photosensitive resin composition according to any one of claims 1 to 5.

**7.** A photosensitive resin plate which comprises a support material and a photosensitive resin composition layer formed thereon, said photosensitive resin composition being that according to any one of claims 1 to 6.

**8.** A relief printing plate having high resistance to waterbased inks, high resilience and excellent form stability, which is prepared by the use of the photosensitive resin plate according to claim 7.

**9.** A method for preparing a water-developable photosensitive resin plate suitable for the manufacture of a relief printing plate having high resistance to water-based inks, high resilience and excellent form stability, which comprises:

(A) a copolymer comprising units of (i) an aliphatic conjugated diene monomer, (ii) an $\alpha$, $\beta$-ethylenically unsaturated carboxylic acid and (iii) a polyfunctional vinyl monomer, optionally with (iv) a monofunctional vinyl monomer, the content of the aliphatic conjugated diene monomer (i), the $\alpha$, $\beta$-ethylenically unsaturated carboxylic acid (ii), the polyfunctional vinyl monomer (iii) and the monofunctional vinyl monomer (iv) being respectively from about 61 to 95 mol % from about 2.5 to 10 mol %, from about 0.5 to 3 mol % and 0 to 70 mol % based on the combination of those monomeric components;
(B) a basic nitrogen atom-containing compound;
(C) an ethylenically unsaturated monomer; and
(D) a photopolymerization initiator, characterized in that a photosensitive composition comprising uniformly the components (A), (B), (C) and (D) without any solvent is molded in a melt state into an appropriate shape.

**10.** The method according to claim 9, wherein the amount of the copolymer (A), the ethylenically unsaturated monomer (C) and the photopolymerization initiator (D) are respectively from about 30 to 90% by weight, from about 5 to 69.99 % by weight and from about 0.01 to 10% by weight, and the amount of the basic nitrogen atom-containing compound (B) is from about 0.20 to 2 mol to 1 mol of the carboxyl groups in the copolymer (A).

**11.** The method according to either of claims 9 and 10 in which the basic nitrogen atom-containing compound (B) is represented by the structural formulae; (I) or (II):

(I)

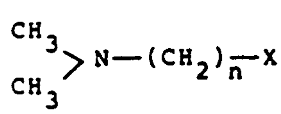

n = 1, 2 or 3
X =

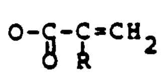 , 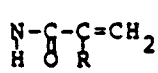 , or 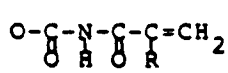

R = H or $CH_3$
(II)

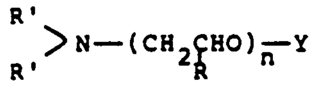

Y = H ,

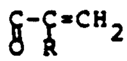 , or 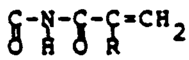

R = H or $CH_3$; n is 1 to 6 when R' i = $CH_3$ and 2 to 6 when R' is $C_2H_5$.

**12.** The method according to claim 11 in which the basic nitrogen atom-containing compound (B) is a photopolymerizable amine compound expressed in formula (I) or (II) except compounds corresponding to formula (II) in which Y is hydrogen.

**13.** The photosensitive resin composition of claim 1, 2 or 3 in which said ethylenically unsaturated monomer (C) includes a polyfunctional monomer.

**14.** A method for preparing a relief printing plate having high resistance to water-based inks, high resilience and excellent form stability, characterized in that the photosensitive resin plate prepared according to any one of claims 9 to 12 is subjected to exposure to light through a negative film having an image and the photosensitive resin composition at the non-exposed part is washed out with water.

**Claims for the following Contracting State : ES**

**1.** A method for preparing a water-developable photosensitive resin plate suitable for the manufacture of a relief printing plate having high resistance to water-based inks, high resilience and excellent form stability, which comprises:

(A) a copolymer comprising units of (i) an aliphatic conjugated diene monomer, (ii) an $\alpha$, $\beta$-ethylenically unsaturated carboxylic acid and (iii) a polyfunctional vinyl monomer, optionally with (iv) a monofunctional vinyl monomer, the content of the aliphatic conjugated diene monomer (i), the $\alpha$, $\beta$-ethylenically unsaturated carboxylic acid (ii), the polyfunctional vinyl monomer (iii), and the monofunctional vinyl monomer (iv), being respectively from about 61 to 95 mol %, from about 2.5 to 10 mol %, from about 0.5 to 3 mol % and 0 to 70 mol % based on the combination of those monomeric components;
(B) a basic nitrogen atom-containing compound;
(C) an ethylenically unsaturated monomer; and
(D) a photopolymerization initiator, characterised in that a photosensitive composition comprising uniformly the components (A), (B), (C) and (D) without any solvent is molded in a melt state into an appropriate shape.

**2.** The method according to claim 1 wherein the amount of the copolymer (A), the ethylenically unsaturated monomer (C) and the photopolymerization initiator (D) are respectively from about 30 to 90% by weight, from about 5 to 69.99% by weight and from about 0.01 to 10% by weight, and the amount of the basic nitrogen atom-containing compound (B) is from about 0.20 to 2 mol to 1 mol of the carboxyl groups in the copolymer (A).

**3.** The method according to either of claims 1 and 2 in which the basic nitrogen atom-containing compound (B) is represented by the structural formulae; (I) or (II);

(I)

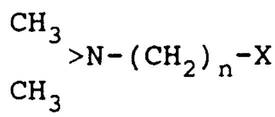

n = 1, 2 or 3
X =

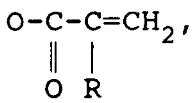, 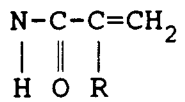, or 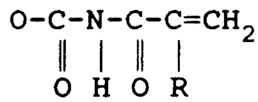

R = H or $CH_3$
(II)

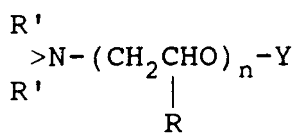

Y = H,

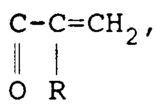, or 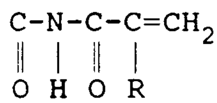

R = H or $CH_3$; n is 1 to 6 when R' is $CH_3$ and 2 to 6 when R' is $C_2H_5$.

**4.** The method according to claim 3 in which the basic nitrogen atom-containing compound (B) is a photopolymerizable amine compound expressed in formula (I) or (II) except compounds corresponding to formula (II) in which Y is hydrogen.

**5.** A method for preparing a relief printing plate having high resistance to water-based inks, high resilience and excellent form stability, characterized in that the photo-sensitive resin plate prepared according to any one of claims 1 to 4 is subjected to exposure to light through a negative film having an image and the photosensitive resin composition at the non-exposed part is washed out with water.

**Patentansprüche**
**Patentansprüche für folgende Vertragsstaaten : AT, BE, CH, DE, FR, GB, GR, IT, LI, LU, NL, SE**

**1.** Durch Wasser entwickelbare, lichtempfindliche Harzzusammensetzung, die nach der Entwicklung Wasserresistenz und Elastizität aufweist, umfassend:
(A) ein Copolymer, umfassend Einheiten aus (i) einem aliphatischen konjugierten Dienmonomer, (ii) einer $\alpha,\beta$-ethylenisch ungesättigten Carbonsäure, und (iii) einen polyfunktionellen Vinylmonomer, wahlweise mit (iv) einem monofunktionellen Vinylmonomer, wobei der Gehalt des aliphatischen konjugierten Dienmonomers (i), der $\alpha,\beta$-ethylenisch ungesättigten Carbonsäure (ii), des polyfunktionellen Vinylmonomers (iii) und des monofunktionellen Vinylmonomers (iv) von etwa 61 bis 95 Mol%, von etwa 2,5 bis 10 Mol%, von etwa 0,5 bis 3 Mol% bzw. 0 bis 70 Mol% ist, bezogen auf die Kombination dieser monomeren Komponenten;
(B) eine Verbindung, die ein basisches Stickstoffatom enthält;
(C) ein ethylenisch ungesättigtes Monomer; und

(D) einen Photopolymerisationsinitiator.

2. Durch Wasser entwickelbare, lichtempfindliche Harzzusammensetzung nach Anspruch 1, dadurch **gekennzeichnet**, daß die Mengen des Copolymers (A), des ethylenisch ungesättigten Monomers (C) und des Photopolymerisationsinitiators (D) von etwa 30 bis 90 Gew.%, von etwa 5 bis 69,99 Gew.% bzw. von etwa 0,01 bis 10 Gew.% sind, und daß die Menge der basischen stickstoffatomhaltigen Verbindung (B) von etwa 0,20 bis 2 Mol zu 1 Mol der Carboxylgruppen in dem Copolymer (A) ist.

3. Durch Wasser entwickelbare, lichtempfindliche Harzzusammensetzung nach Anspruch 1 oder 2, dadurch **gekennzeichnet**, daß die basische, stickstoffatomhaltige Verbindung (B) durch die strukturellen Formeln gekennzeichnet ist:

(I)

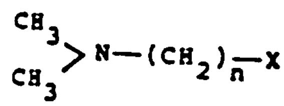

n = 1, 2 oder 3

X =

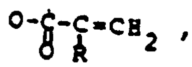 , 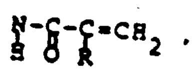 , oder 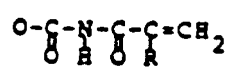

R = H oder $CH_3$

(II)

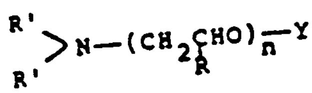

Y = H ,

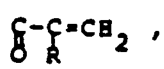 , oder 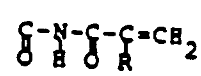

worin R = H oder $CH_3$; n ist 1 bis 6, wenn R' $CH_3$ ist und 2 bis 6, wenn R' $C_2H_5$ ist.

4. Durch Wasser entwickelbare, lichtempfindliche Harzzusammensetzung nach Anspruch 3, dadurch **gekennzeichnet**, daß die basische stickstoffhaltige Verbindung (B) eine photopolymerisierbare Aminverbindung ist, dargestellt in Formel (I) oder (II), mit Ausnahme von Verbindungen, die der Formel (II) entsprechen, worin Y Wasserstoff ist.

5. Durch Wasser entwickelbare, lichtempfindliche Harzzusammensetzung nach einem der Ansprüche 1 bis 4, dadurch **gekennzeichnet**, daß sie auf einem Trägermaterial getragen ist.

6. Reliefdruckplatte mit einer hohen Resistenz gegen Tinten auf Wasserbasis, hohen Elastizität und einer ausgezeichneten Formstabilität, hergestellt durch die Verwendung der lichtempfindlichen Harzzusammensetzung nach einem der Ansprüche 1 bis 5.

7. Lichtempfindliche Harzplatte, umfassend ein Trägermaterial und eine lichtempfindliche Harzzusammensetzungsschicht, die darauf gebildet ist, wobei die lichtempfindliche Harzzusammensetzung nach einem der Ansprüche 1 bis 6 definiert ist.

8. Reliefdruckplatte mit hoher Resistenz gegen Tinten auf Wasserbasis, hoher Elastizität und ausgezeichneter Formstabilität, hergestellt durch die Verwendung der lichtempfindlichen Harzplatte nach Anspruch 7.

9. Verfahren zur Herstellung einer durch Wasser entwickelbaren, lichtempfindlichen Harzplatte, die zur Herstellung einer Reliefdruckplatte mit hoher Resistenz gegen Tinten auf Wasserbasis, hoher Elastizität und ausgezeichneter Formstabilität geeignet ist, umfassend: (A) ein Copolymer, umfassend Einheiten aus (i) einem aliphatischen konjugierten Dienmonomer, (ii) einer $\alpha,\beta$-ethylenisch ungesättigten Carbonsäure, und (iii) einem polyfunktionellen Vinylmonomer, wahlweise mit (iv) einem monofunktionellen Vinylmonomer, wobei der Gehalt des aliphatischen konjugierten Dienmonomers (i), der $\alpha,\beta$-ethylenisch ungesättigten Carbonsäure (ii), des polyfunktionellen Vinylmonomers (iii) und des monofunktionellen Vinylmonomers (iv) von etwa 61 bis 95 Mol%, von etwa 2,5 bis 10 Mol%, von etwa 0,5 bis 3 Mol% bzw. 0 bis 70 Mol% ist, bezogen auf die Kombination dieser monomeren Komponenten;
(B) eine Verbindung, die ein basisches Stickstoffatom enthält;
(C) ein ethylenisch ungesättigtes Monomer; und
(D) einen Photopolymerisationsinitiator,
dadurch **gekennzeichnet**, daß
aus einer lichtempfindlichen Zusammensetzung, die gleichmäßig die Komponenten (A), (B), (C) und (D) enthält, ohne irgendein Lösungsmittel in einem geschmolzenen Zustand eine geeignete Form gebildet wird.

10. Verfahren nach Anspruch 9,
dadurch **gekennzeichnet**, daß
die Mengen des Copolymers (A), des ethylenisch ungesättigten Monomers (C) und des Photopolymerisationsinitiators (D) von etwa 30 bis 90 Gew.%, von etwa 5 bis 69,99 Gew.% bzw. von etwa 0,01 bis 10 Gew.% sind, und daß die Menge der basischen stickstoffatomhaltigen Verbindung (B) von etwa 0,20 bis 2 Mol zu 1 Mol der Carboxylgruppen in dem Copolymer (A) ist.

11. Verfahren nach einem der Ansprüche 9 und 10,
dadurch **gekennzeichnet**, daß die basische, stickstoffatomhaltige Verbindung (B) durch die strkturellen Fromeln (I) oder (II) gekennzeichnet ist:
(I)

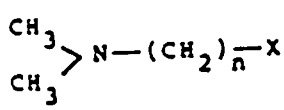

n = 1, 2 oder 3
X =

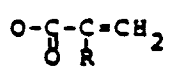 , 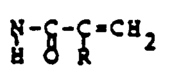 , oder 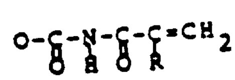

R = H oder $CH_3$

(II)

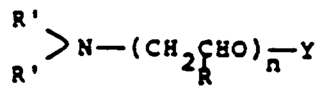

Y = H ,

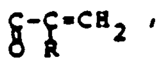 oder 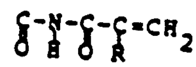

worin R = H oder $CH_3$; n ist 1 bis 6, wenn R' $CH_3$ ist und 2 bis 6, wenn R' $C_2H_5$ ist.

**12.** Verfahren nach Anspruch 11, dadurch **gekennzeichnet**, daß die basische stickstoffhaltige Verbindung (B) eine photopolymerisierbare Aminverbindung, dargestellt in Formel (I) oder (II) ist, mit Ausnahme von Verbindungen, die der Formel (II) entsprechen, worin Y Wasserstoff ist.

**13.** Lichtempfindliche Harzusammensetzung nach Anspruch 1, 2, oder 3, dadurch **gekennzeichnet**, daß das ethylenisch ungesättigte Monomer (C) ein polyfunktionelles Monomer umfaßt.

**14.** Verfahren zur Herstellung einer Reliefdruckplatte mit hoher Resistenz gegen Tinten auf Wasserbasis, hoher Elastizität und einer ausgezeichneten Formstabilität, dadurch **gekennzeichnet**, daß die lichtempfindliche Harzplatte, hergestellt nach einem der Ansprüche 9 bis 12, mit einem Licht durch einen Negativfilm mit einem Bild belichtet wird und daß die lichtempfindliche Harzzusammensetzung an dem nicht belichteten Teil mit Wasser ausgewaschen wird.

**Patentansprüche für folgenden Vertragsstaat : ES**

**1.** Verfahren zur Herstellung einer durch Wasser entwickelbaren, lichtempfindlichen Harzplatte, geeignet für die Herstellung einer Reliefdruckplatte mit hoher Resistenz gegen Tinten auf Wasserbasis, hoher Elastizität und ausgezeichneter Formstabilität, umfassend:
(A) ein Copolymer, umfassend Einheiten aus (i) einem aliphatischen konjugierten Dienmonomer, (ii) einer $\alpha,\beta$-ethylenisch ungesättigten Carbonsäure und (iii) einem polyfunktionellen Vinylmonomer, wahlweise mit (iv) einem monofunktionellen Vinylmonomer, wobei der Gehalt des aliphatischen konjugierten Dienmonomers (i) der $\alpha,\beta$-ethylenisch ungesättigten Carbonsäure, (ii) des polyfunktionellen Vinylmonomers, (iii) und des monofunktionellen Vinylmonomers (iv) von etwa 61 bis 95 Mol%, von etwa 2,5 bis 10 Mol%, von etwa 0,5 bis 3 Mol% bzw. 0 bis 70 Mol% ist, bezogen auf die Kombination dieser monomeren Komponenten;
(B) eine Verbindung, die ein basisches Stickstoffatom enthält;
(C) ein ethylenisch ungesättigtes Monomer; und
(D) einen Photopolymerisationsinitiator, dadurch gekennzeichnet, daß eine lichtempfindliche Zusammensetzung, die die Komponenten (A), (B), (C) und (D) gleichmäßig enthält, ohne irgendein Lösungsmittel in einem Schmelzzustand in eine geeignete Form gebracht wird.

**2.** Verfahren nach Anspruch 1, worin die Mengen des Copolymers (A), des ethylenisch ungesättigten Monomers (C) und des Photopolymerisationsinitiators (D) von etwa 30 bis 90 Gew.%, von etwa 5 bis 69,99 Gew.% bzw. von etwa 0,01 bis 10 Gew.% sind und worin die Menge der basischen stickstoffatomhaltigen Verbindung (B) von etwa 0,20 bis 2 Mol zu 1 Mol der Carboxylgruppen in dem Copolymer (A) ist.

3. Verfahren nach einem der Ansprüche 1 und 2, worin die basische, stickstoffatomhaltige Verbindung (B) durch die strukturellen Formeln (I) oder (II) dargestellt ist:
(I)

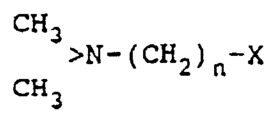

n = 1, 2 oder 3
X =

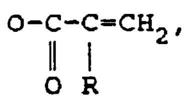 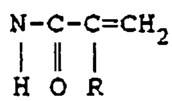 oder 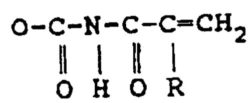

R = H oder $CH_3$
(II)

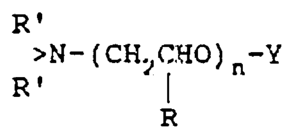

Y = H,

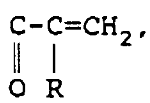 oder 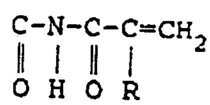

worin R = H oder $CH_3$; n ist 1 bis 6, wenn R' $CH_3$ ist, und 2 bis 6, wenn R' $C_2H_5$ ist.

4. Verfahren nach Anspruch 3, worin die basische stickstoffhaltige Verbindung (B) eine photopolymerisierbare Aminverbindung ist, dargestellt in Formel (I) oder (II), mit der Ausnahme von Verbindungen, die der Formel (II) entsprechen, worin Y Wasserstoff ist.

5. Verfahren zur Herstellung einer Reliefdruckplatte mit hoher Resistenz gegen Tinten auf Wasserbasis, hoher Elastizität und einer ausgezeichneten Formstabilität,
dadurch **gekennzeichnet**, daß
die lichtempfindliche Harzplatte, hergestellt nach einem der Ansprüche 1 bis 4 mit Licht durch einen Negativfilm mit einem Bild belichtet wird und daß die lichtempfindliche Harzzusammensetzung an dem nichtbelichteten Bereich mit Wasser ausgewaschen wird.

**Revendications**
**Revendications pour les Etats contractants suivants : DE, FR, GB, GR, IT, LI, LU, NL, SE**

1. Composition de résine photosensible, pouvant être développée à l'eau, conférant de l'élasticité et de la résistance à l'eau après développement, caractérisée en ce qu'elle comprend :
(A) un copolymère comprenant des unités de (i) un monomère du type diène conjugué aliphatique, (ii) un acide carboxylique $\alpha,\beta$-éthyléniquement insaturé et (iii) un monomère vinylique polyfonctionnel, éventuellement avec (iv) un monomère vinylique monofonctionnel, la teneur en monomère du type diène conjugué aliphatique (i), l'acide carboxylique $\alpha,\beta$-éthyléniquement insaturé (ii), le monomère vinylique polyfonctionnel (iii) et le monomère vinylique monofonctionnel (iv) représentant, respectivement, d'environ 61 à 95% molaires, d'environ 2,5 à 10% molaires, d'environ 0,5 à 3%

molaires et de 0 à 70% molaires, sur base de la combinaison de ces composants monomériques;
(B) un composé contenant de l'azote basique;
(C) un monomère éthyléniquement insaturé, et
(D) un amorceur de photopolymérisation.

2. Composition de résine photosensible, susceptible d'être développée à l'eau, suivant la revendication 1, caractérisée en ce que les proportions du polymère (A), du monomère éthyléniquement insaturé (C) et de l'amorceur de photopolymérisation (D) varient, respectivement, d'environ 30 à 90% en poids, d'environ 5 à 69,99% en poids et d'environ 0,01 à 10% en poids, et la proportion du composé contenant de l'azote basique (B) varie d'environ 0,20 à 2 moles pour 1 mole des radicaux carboxyle dans le copolymère (A).

3. Composition de résine photosensible, susceptible d'être développée à l'eau, suivant la revendication 1 ou 2, caractérisée en ce que le composé contenant de l'azote basique (B) est représenté par les formules de structure suivantes :
(I)

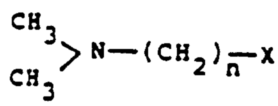

n = 1, 2 ou 3
X =

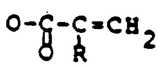 , 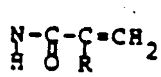 , ou 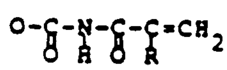

R = H ou $CH_3$
(II)

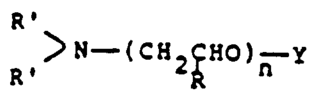

Y = H ,

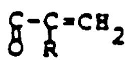 , ou 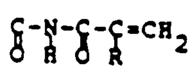

dans lesquelles R représente un atome d'hydrogène ou le radical $CH_3$; n a une valeur qui varie de 1 à 6 lorsque R' représente le radical $CH_3$ et de 2 à 6 lorsque R' représente le radical $C_2H_5$.

4. Composition de résine photosensible, susceptible d'être développée à l'eau, suivant la revendication 3, caractérisée en ce que le composé contenant de l'azote basique (B) est un composé du type amine photopolymérisable, représenté par la formule (I) ou (II), à l'exception des composés correspondant à la formule (II) dans laquelle Y représente un atome d'hydrogène.

5. Composition de résine photosensible, susceptible d'être développée à l'eau, suivant l'une quelconque des revendications 1 à 4, caractérisée en ce qu'elle est portée par un matériau de support.

6. Cliché ou plaque d'impression en relief ou typographique possédant une haute résistance aux encres à base d'eau, une élasticité ou souplesse élevée et une excellente stabilité de formes, que l'on prépare par l'emploi d'une composition de résine photosensible suivant l'une quelconque des revendications 1

à 5.

**7.** Plaque de résine photosensible, caractérisée en ce qu'elle comprend un matériau de support et une couche de composition de résine photosensible formée sur ce matériau, ladite composition de résine photosensible étant telle que celle conforme à l'une quelconque des revendications 1 à 6.

**8.** Plaque ou cliché d'impression en relief ou typographique possédant une haute résistance aux encres à base d'eau, une élasticité ou souplesse élevée et une excellente stabilité de formes, que l'on prépare par l'utilisation de la plaque de résine photosensible suivant la revendication 7.

**9.** Procédé pour fabriquer une plaque de résine photosensible, susceptible d'être développée à l'eau, convenant à la confection d'une plaque ou cliché d'impression en relief ou typographique, possédant une haute résistance aux encres à base d'eau, une élasticité ou souplesse élevée et une excellente stabilité de formes, qui comprend :

(A) un copolymère comprenant des unités de (i) un monomère du type diène conjugué aliphatique, (ii) un acide carboxylique $\alpha,\beta$-éthyléniquement insaturé et (iii) un monomère vinylique polyfonctionnel, éventuellement avec (iv) un monomère vinylique monofonctionnel, la teneur en monomère du type diène conjugué aliphatique (i), en acide carboxylique $\alpha,\beta$-éthyléniquement insaturé (ii), en monomère vinylique polyfonctionnel (iii) et monomère vinylique monofonctionnel (iv) représentant, respectivement, d'environ 61 à 95% molaires, d'environ 2,5 à 10% molaires, d'environ 0,5 à 3% molaires et de 0 à 70% molaires, sur base de la combinaison de ces composants monomériques;
(B) un composé contenant de l'azote basique;
(C) un monomère éthyléniquement insaturé, et
(D) un amorceur de photopolymérisation,

caractérisé en ce que l'on moule une composition photosensible comprenant uniformément les composants (A), (B), (C) et (D) sans un quelconque solvant à l'état fondu en une forme appropriée.

**10.** Procédé suivant la revendication 9, caractérisé en ce que la proportion du copolymère (A), du monomère éthyléniquement insaturé (C) et de l'amorceur de photopolymérisation (D) varie, respectivement, d'environ 30 à 90% en poids, d'environ 5 à 69,99% en poids et d'environ 0,01 à 10% en poids, et la proportion du composé contenant de l'azote basique (B) varie d'environ 0,20 à 2 moles pour 1 mole des radicaux carboxyle dans le copolymère (A).

**11.** Procédé suivant l'une quelconque des revendications 9 et 10, caractérisé en ce que le composé contenant de l'azote basique (B) est représenté par les formules de structure suivantes :

(I)

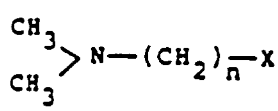

n = 1, 2 ou 3
X =

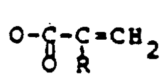 , 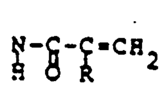 , ou 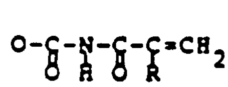

R = H ou $CH_3$

(II)

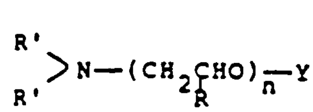

Y = H ,

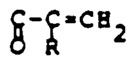 , ou 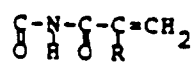

dans lesquelles R représente un atome d'hydrogène ou le radical $CH_3$; n a une valeur qui varie de 1 à 6 lorsque R' représente le radical $CH_3$ et de 2 à 6 lorsque R' représente le radical $C_2H_5$.

**12.** Procédé suivant la revendication 11, caractérisé en ce que le composé contenant de l'azote basique (B) est un composé du type amine photopolymérisable, représente par la formule (I) ou (II), à l'exception des composés correspondant à la formule (II) dans laquelle Y représente un atome d'hydrogène.

**13.** Composition de résine photosensible suivant la revendication 1, 2 ou 3, caractérisée en ce que le monomère éthyléniquement insaturé (C) précité comprend un monomère polyfonctionnel.

**14.** Procédé de fabrication d'une plaque ou cliché d'impression en relief ou typographique possédant une haute résistance aux encres à base d'eau, une élasticité ou souplesse élevée et une excellente stabilité de formes, caractérisé en ce que l'on soumet la plaque de résine photosensible confectionnée suivant l'une quelconque des revendications 9 à 12, à une exposition à de la lumière à travers un film négatif possédant une image et on lixivie la composition de résine photosensible de la partie non exposée.

**Revendications pour l'Etat Contractant suivant : ES**

**1.** Procédé pour fabriquer une plaque de résine photosensible, susceptible d'être développée à l'eau, convenant à la confection d'une plaque d'impression en relief, possédant une haute résistance aux encres à base d'eau, une élasticité ou souplesse élevée et une excellente stabilité de formes, qui comprend :

(A) un copolymère comprenant des unités de (i) un monomère du type diène conjugué aliphatique, (ii) un acide carboxylique $\alpha,\beta$-éthyléniquement insaturé et (iii) un monomère vinylique polyfonctionnel, éventuellement avec (iv) un monomère vinylique monofonctionnel, la teneur en monomère du type diène conjugué aliphatique (i), en acide carboxylique $\alpha,\beta$-éthyléniquement insaturé (ii), en monomère vinylique polyfonctionnel (iii) et monomère vinylique monofonctionnel (iv) variant, respectivement, d'environ 61 à 95 % molaires, d'environ 2,5 à 10 % molaires, d'environ 0,5 à 3 % molaires et de 0 à 70 % molaires, par rapport à la combinaison de ces composants monomériques ,
(B) un composé contenant de l'azote basique;
(C) un monomère éthyléniquement insaturé ; et
(D) un amorceur de photopolymérisation,

caractérisé en ce que l'on moule une composition photosensible comprenant uniformément les composants (A), (B), (C) et (D) sans un quelconque solvant, à l'état fondu, en une forme appropriée.

**2.** Procédé selon la revendication 1, caractérisé en ce que la proportion du copolymère (A), du monomère éthyléniquement insaturé (C) et de l'amorceur de polymérisation (D) varie, respectivement, d'environ 30 à 90 % en poids, d'environ 5 à 69,99 % en poids et d'environ 0,01 à 10 % en poids, et la proportion du composé contenant de l'azote basique (B) varie d'environ 0,20 à 2 moles pour 1 mole de radicaux carboxyles dans le copolymère (A).

**3.** Procédé selon l'une quelconque des revendications 1 et 2, caractérisé en ce que le composé contenant de l'azote basique (B) est représenté par les formules de structure (I) ou (II) suivantes :

(I)

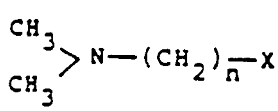

n = 1, 2 ou 3
X =

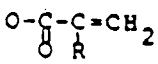 , 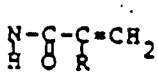 , ou 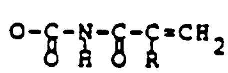

R = H ou $CH_3$

(II)

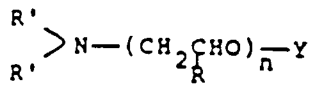

Y = H ,

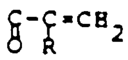 , ou 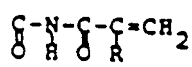

dans lesquelles R = H ou $CH_3$ ; n a une valeur qui varie de 1 à 6 lorsque R' est $CH_3$ et de 2 à 6 lorsque R' est $C_2H_5$.

**4.** Procédé selon la revendication 3, dans lequel le composé contenant de l'azote basique (B) est un composé du type amine photopolymérisable, représenté par la formule (I) ou (II), à l'exception des composés correspondant à la formule (II) dans laquelle Y représente un atome d'hydrogène.

**5.** Procédé de fabrication d'un plaque d'impression en relief, possédant une haute résistance aux encres à base d'eau, une élasticité ou souplesse élevée et une excellente stabilité de formes, caractérisé en ce que l'on soumet la plaque de résine photosensible, confectionnée selon l'une quelconque des revendications 1 à 4, à une exposition à la lumière à travers un film négatif possédant une image, et on élimine par lavage la composition de résine photosensible de la partie non exposée.